Europäisches Patentamt

**European Patent Office**

**Office européen des brevets**

(11) Publication number: **0 202 755**

**A1**

(12) **EUROPEAN PATENT APPLICATION**

(21) Application number: **86302730.6**

(22) Date of filing: **11.04.86**

(51) Int. Cl.4: **H01L 29/80** , H01L 29/64

(30) Priority: **19.04.85 US 725289**

(43) Date of publication of application:
**26.11.86 Bulletin 86/48**

(84) Designated Contracting States:
**DE FR GB IT**

(71) Applicant: **International Business Machines Corporation**
**Old Orchard Road**
**Armonk, N.Y. 10504(US)**

(72) Inventor: **Freeouf, John Lawrence**
**East Mountain Lake Katonah Route 3**
**Katonah New York 10536(US)**
Inventor: **Jackson, Thomas Nelson**
**80 Cortlandt Avenue**
**Peekskill New York 10566(US)**
Inventor: **Kirchner, Peter Daniel**
**Route 9**
**Garrison New York 10524(US)**

(74) Representative: **Hobbs, Francis John**
**IBM United Kingdom Limited Intellectual**
**Property Department Hursley Park**
**Winchester Hampshire SO21 2JN(GB)**

(54) **Double heterojunction field effect transistor data storage device.**

(57) Reversible control of conduction in a band offset heterojunction field effect transistor device is achieved by an asymmetric barrier (10) which can position a potential well across the Fermi level to produce conduction and away from the Fermi level for a non-conducting condition and to retain that position in the absence of a signal. The device can be a GaAs channel FET with a multilayer gate comprising, in order of proximity to the GaAs channel, a gate layer (3) of GaAlAs, a charge storage layer (8) of GaAs, an asymmetric barrier layer (10) of GaAlAs graded towards the GaAs storage layer and an ohmic adapting layer (13) of GaAs.

# A DOUBLE HETEROJUNCTION FIELD EFFECT TRANSISTOR DATA STORAGE DEVICE

The invention relates to a double heterojunction field effect transistor data storage device.

In devices known as high electron mobility transistors (HEMT), a number of electrons are trapped in a potential well which appears at a lattice matched heterojunction with a band offset. In such a structure when conduction in the channel of a Field Effect Transistor employs such a heterojunction, the speed of response substantially increases. Such a structure has been known also as a modulation doped and an electron gas type structure. Such a structure is disclosed in US-A-4,163,237. The use of one material of the heterojunction as the gate of a FET with a contiguous region thereto used to move the potential well with respect to the Fermi level for the purpose of setting a specific threshold, is disclosed in EP-A-114762. A semiconductor electronically erasable memory structure involving varying insulator properties adjacent to a silicon FET channel is shown in J Applied Phys $50$ (9), September 1979, page 5826.

The invention seeks to provide a double heterojunction field effect transistor data storage device.

Such a device comprises, according to the invention, a substrate of single crystal semiconductor material having disposed therein spaced apart source and drain regions defining a channel region there-between, a gate layer of single crystal semiconductor material which has a larger bandgap than that of the substrate, forming a heterojunction with the substrate and disposed over the channel region, a charge storage layer of semiconductor material forming a heterojunction with the gate layer and disposed over the channel region, the energy band difference between the gate and charge storage layers being substantially equal to that between the substrate and the gate layer, charge transfer means, having an asymmetric charge transfer characteristic, contiguous with the face of the charge storage layer opposite to that forming the heterojunction with the gate layer and charge introduction and removal means contiguous with the charge transfer means.

How the invention can be carried out will now be described by way of example, with reference to the accompanying drawings, in which:-

Figure 1 represents a semiconductor device embodying the invention;

Figure 2 indicates the mole fraction of A1 in specific regions of a GaAs-Ga $_{1-x}$A1$_x$As em-

bodiment of the invention;

Figure 3 indicates the n-doping concentration in specific regions of a GaAs-Ga$_{1-x}$A1$_x$As embodiment of the invention;

Figure 4 is a band energy diagram correlated with the structure of Figure 1, indicating the respective energy levels in the quiescent state;

Figure 5 is a band energy diagram correlated with the structure of Figure 1, indicating the respective energy levels when a charge is being stored that turns the device "on" and produces conduction;

Figure 6 is a band energy diagram correlated with the structure of Figure 1, indicating the respective energy levels after removal of the charge storage signal that turned the device "on" and produced conduction;

Figure 7 is a band energy diagram correlated with the structure of Figure 1, indicating the respective energy levels during removal of a charge that produces the "off" or non-conducting condition; and

Figure 8 is a band energy diagram correlated with Figure 1, after removal of the signal that removed the ·charge and produced the non-conducting or "off" condition.

The invention is concerned with a band offset heterojunction FET having a charge storage and removal capability that operates to position and retain, in the absence of signal, the potential well with respect to the Fermi level, so that the FET is either in a conducting or non-conducting state. A charge is stored in a semiconductor region that forms a barrier with the gate of a band offset heterojunction FET and employs asymmetry in a second barrier to permit charge introduction and removal in response to a signal.

In the following description of a preferred embodiment of the invention, reference is made to specific semiconductor materials, doping types and concentrations, and physical conduction mechanisms, however, in the light of the principles set forth, various substitutions will be apparent to one skilled in the art.

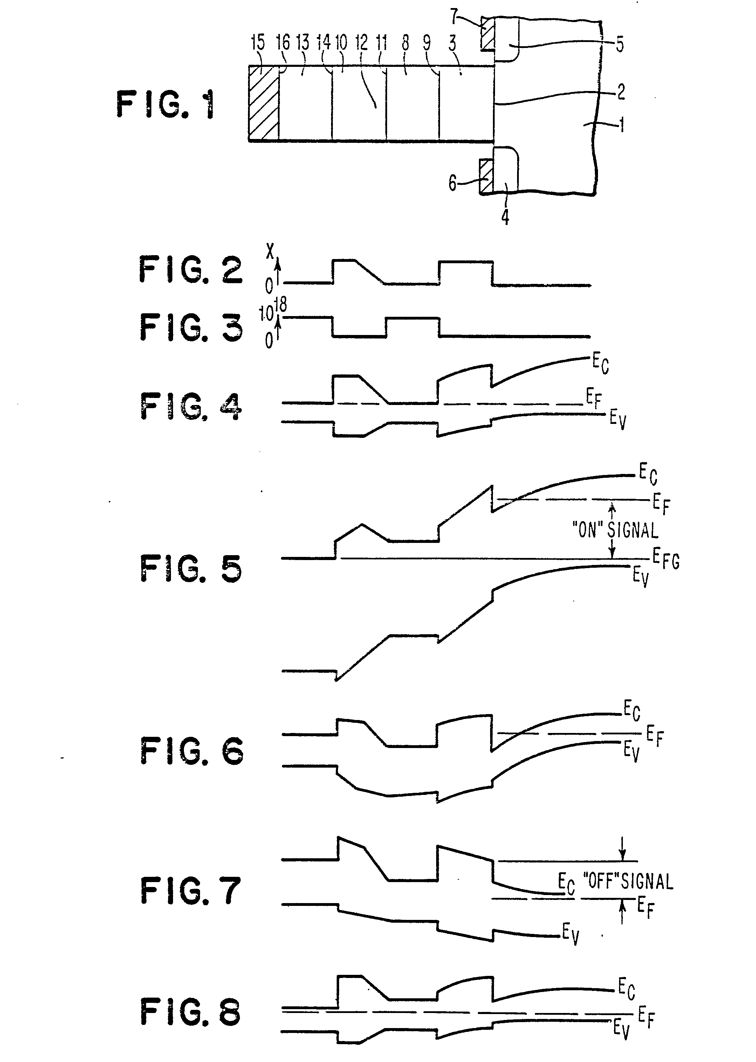

Referring to Figure 1, the preferred embodiment has a substrate 1 formed of a first semiconductor having a relatively small band gap such as GaAs. A heterojunction interface 2 exists between the substrate 1 and a second semiconductor 3 having a wider band gap, such as $Ga_xAl_{1-x}As$. The heterojunction interface 2 provides a potential well that serves as the channel region of the field effect transistor type device. The channel at the interface 2 is terminated at heavily doped source 4 and drain 5 regions, each with a respective ohmic electrode 6 and 7. A charge storage region 8 forms a barrier 9 with the region 3. The region 8 is of GaAs which, having a smaller band gap than that of the $Ga_xAl_{1-x}As$, provides a heterojunction barrier at 9.

A charge transfer accommodation region 10 forms a barrier 11 with region 8. The charge transfer accommodation region transfers charge to the region 8 in the presence of a signal of one polarity, transfers charge out of the region 8 in the presence of a signal of the opposite polarity while operating to prevent change of charge state of the region 8 in the no signal condition. The region 10 is of $Ga_xAl_{1-x}As$, epitaxial with the GaAs region 8 at a heterojunction barrier 11. Portion 12 of the region 10 adjacent the barrier 11 of the larger GaAlAs band gap is graded progressively down to GaAs at the barrier 11. An ohmic contact for signal introduction purposes is provided with a doped, smaller band gap region 13, such as GaAs, epitaxial with region 10 at the heterojunction barrier 14 and a metal member 15 at the face 16.

The structure of Figure 1 can be manufactured using most standard techniques in the art capable of crystal perfection, composition and doping control. A preferred technique because of low temperature operation and the ability to make abrupt change is the technique of molecular beam epitaxy. The structure of Figure 1 would be made with the substrate 1, region 8 and region 13 of n-type GaAs and regions 3 and 10 of $Ga_xAl_{1-x}As$ with the mole fraction of Al varying in the region 12. It will be apparent to one skilled in the art that the substrate 1 can be a buffer layer on a larger supporting member not shown.

The molecular beam epitaxy technique would provide successive layers on the interface 2 of the substrate. Referring to Figures 2 and 3, the first layer would be the $Ga_xAl_{1-x}As$ region 3 grown on the interface 2 with the mole fraction of Al as shown in Figure 2 sufficiently high, with x around 0.5, to produce the $Ga_xAl_{1-x}As$. The next layer would be the region 8 of GaAs in which, referring to Figures 2 and 3, there would be no Al introduced but the n dopant would be introduced. The following layer would be the region 10 in which, again referring to Figures 2 and 3, there would be no n dopant while the mole fraction of Al would at this point be progressively increased in region 12 from zero or pure GaAs at interface 11 to around x = 0.5, thereby grading the band gap of the GaAlAs in the region 12 adjacent the interface 11.

The remainder of region 10 to interface 14 would be grown at a constant value of x. The final layer would be GaAs grown on interface 14 with, referring to Figures 2 and 3, no Al mole fraction and n dopant. The metal 15 would be vacuum evaporated.

The energy band diagram of Figures 4 to 8 illustrates the operation of the device. Figure 4 shows the quiescent state of the device. Figures 5 and 6 show the way the structure provides the ability to store a charge in response to a signal that will position the potential well across the Fermi level with the condition being retained in the absence of signal. Figures 7 and 8 then show the way the charge is removed so that the potential well is no longer across the Fermi level, and that the condition is retained in the absence of signal.

Referring to Figure 4, the energy band diagram of the structure of Figure 1 is shown in the quiescent state wherein the conduction band is in the vicinity of the Fermi level in the regions 13 and 8 and is above the Fermi level in the regions 10 and 3. The offset at the potential well at the interface 2 is above the Fermi level so that the device would not conduct.

In Figure 5, a turn-on signal is applied. This condition stores a charge in region 8 which in turn operates to position the potential well across the Fermi level at the interface 2 to establish the conditions for conduction.

In Figure 6, when the signal is removed, the charge on region 8 placing the conduction band below the Fermi level cannot leak off due to the gradual shift to a higher band gap in the portion 12 of region 10. The charge in region 8 in turn retains the potential well across the Fermi level in the absence of signal. Thus, once set to "on", the device conducts in the absence of any further signal.

The band energy diagrams in Figures 7 and 8 illustrate the conditions for removal of the charge on region 8 producing the non-conducting condition.

Referring next to Figure 7, the relative positions of the band energy diagrams are shown under the conditions where an "off" signal is applied. The signal is of a polarity opposite to that of Figure 5 which operates to move the charge out of region 8 toward the inter face 2. The graded aspect of portion 12 of region 10 facilitates moving the charge out of region 10. The asymmetric barrier in region 10 could also be achieved by a tunnelling structure.

In Figure 8, after the turn off signal is removed, the band energy diagram is such that the potential well is retained above the Fermi level and consequently no conduction takes place.

With a signal applied between the substrate 1 and the gate contact 15, due to the asymmetric storage performance of the layer 10, charge can be removed via the gate electrode from the region 8 more easily than it can be added via the channel. This results in the quasi-Fermi level of the layer 8 being closer to that of the top layer 13 than to the bottom layer 1. The structural configuration provides a charge which moves the conduction band with respect to the Fermi level such that a potential well can be positioned across the Fermi level in one condition at which point conduction can occur or the potential well can be removed from across the Fermi level so that conduction will not occur.

In a preferred embodiment of the structure of Figure 1, the substrate 1 is of semi-insulating GaAs and the regions 4 and 5 are doped with silicon to about $10^{18}$ atoms/cc. The ohmic contacts 6 and 7 are standard alloyed AuGe based.

The region 3 is substantially undoped GaAlAs with the aluminium mole fraction being 0.5 so that it would be described as $Ga_{0.5}Al_{0.5}As$. The region 8 is of GaAs, doped to a concentration of about $10^{18}$ atoms/cc with silicon, as is the region 13. The region 9 is of $Ga_xAl_{1-x}As$ with the portion adjacent to the interface 11 provided with a gradually increasing mole fraction of Al from zero (i.e GaAs) at the interface 11 to $Ga_{0.5}Al_{0.5}As$ at the end of portion 12.

In the preferred embodiment, each of the epitaxial regions 3, 8, 12 and 13 is about 50 nm thick. The gate structure can be delineated to permit application of the source 4 and drain 5 and contacts 6 and 7 by reactive ion etching or chemical etching. The difference in response to etching by GaAs and GaAlAs is usable to expose the interface 2.

The structure of Figure 1 is responsive to "on" and "off" signals in the 1 to 2 volt range.

What has been described is a semiconductor storage device which provides reversible control by conduction in a band offset heterojunction FET by providing an asymmetric barrier controlled charge storage capability that can position a potential well across the Fermi level for conduction, and away from the Fermi level for non-conduction and to retain in that position in the absence of a signal.

## Claims

1. A double heterojunction field effect transistor data storage device comprising a substrate (1) of single crystal semiconductor material having disposed therein spaced apart source and drain regions (4.5) defining a channel region there-between, a gate layer (3) of single crystal semiconductor material which has a larger bandgap than that of the substrate, forming a heterojunction (2) with the substrate and disposed over the channel region, a charge storage layer (8) of semiconductor material forming a heterojunction (9) with the gate layer and disposed over the channel region, the energy band difference between the gate and charge storage layers being substantially equal to that between the substrate and the gate layer charge transfer means (10), having an asymmetric charge transfer characteristic, contiguous with the face of the charge storage layer opposite to that forming the heterojunction (9) with the gate layer and charge introduction and removal means - (13,15) contiguous with the charge transfer means - (10).

2. A device as claimed in claim 1, in which the charge transfer means consists of a layer of a graded band gap semiconductor material.

3. A device as claimed in claim 1, in which the charge transfer means consists of a tunnelling barrier.

4. A device as claimed in any preceding claim, in which the charge introduction and removal means comprises an epitaxial layer of semiconductor material contacting the charge transfer means.

5. A device as claimed in Claim 2 in which the substrate and the charge storage layer are of GaAs and the gate layer and the charge transfer means are of GaAlAs.

6. A device as claimed in claim 5, in which the signal introduction and removal means comprises an epitaxial layer of GaAs contacting the charge transfer layer and an ohmic contact contacting that GaAs layer.

**0 202 755**

# FIG. 1

15 16 13 14 10 12 11 8 9 3

7

5

2

1

6

4

# FIG. 2

$X$

$0$

# FIG. 3

$10^{18}$

$0$

# FIG. 4

$E_C$

$E_F$

$E_V$

# FIG. 5

$E_C$

$E_F$

"ON" SIGNAL

$E_{FG}$

$E_V$

# FIG. 6

$E_C$

$E_F$

$E_V$

# FIG. 7

$E_C$ "OFF" SIGNAL

$E_F$

$E_V$

# FIG. 8

$E_C$

$E_F$

$E_V$

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| Y | IBM TECHNICAL DISCLOSURE BULLETIN, vol. 25, no. 3A, August 1982, page 1250, New York, US; M.H. BRODSKY et al.: "GaAs electrically alterable read-only memory" | 1,2,5 | H 01 L 29/80<br>H 01 L 29/64 |
| | --- | | |
| Y | APPLIED PHYSICS LETTERS, vol. 45, no. 12, December 1984, pages 1294-1296, New York, US; S. LURYI et al.: "Hot-electron memory effect in double-layered heterostructures"<br>* page 1295, paragraph 1 * | 1,2,5 | |
| | --- | | |
| A | EP-A-0 114 962 (IBM)<br>* page 5, last paragraph * | 1,5 | |
| | --- | | TECHNICAL FIELDS SEARCHED (Int. Cl.4) |
| A | PATENT ABSTRACTS OF JAPAN, vol. 8, no. 84 (E-239)[1521], 18th. April 1984; & JP - A - 59 4085 (FUJITSU) 10-01-1984 | 1,2,5 | G 11 C 17/00<br>H 01 L 29/36<br>H 01 L 29/58<br>H 01 L 29/80 |
| | --- | | |
| A,D | JOURNAL OF APPLIED PHYSICS LETTERS, vol. 50, no. 9, September 1979, pages 5826-5829, New York, US; D.J. DiMARIA "Graded or stepped energy band-gap-insulator MIS structures (GI-MIS or SI-MIS)"<br>* page 5828, paragraph 3 * | 1,2 | |
| | ----- | | |

The present search report has been drawn up for all claims

| Place of search | Date of completion of the search | Examiner |
|---|---|---|
| BERLIN | 15-08-1986 | GIBBS C.S. |

CATEGORY OF CITED DOCUMENTS

X : particularly relevant if taken alone
Y : particularly relevant if combined with another document of the same category
A : technological background
O : non-written disclosure
P : intermediate document

T.: theory or principle underlying the invention
E : earlier patent document, but published on, or after the filing date
D : document cited in the application
L : document cited for other reasons

& : member of the same patent family, corresponding document

EPO Form 1503 03 82